## Europäisches Patentamt
## European Patent Office
## Office européen des brevets

(11) Publication number: **0 205 686**
**A1**

(12) # EUROPEAN PATENT APPLICATION

(21) Application number: **85304206.7**

(22) Date of filing: **13.06.85**

(51) Int. Cl.⁴: **H 01 L 23/48**

(43) Date of publication of application: **30.12.86**
**Bulletin 86/52**

(84) Designated Contracting States: **DE FR GB NL**

(71) Applicant: **KIDD, INC., 524-11, Ohi Tsukui-machi, Tsukui-gun Kanagawa-ken (JP)**

(72) Inventor: **Kimura, Shoichi, 524-11, Ohi Tsukui-Machi, Tsukui-gun Kanagawa-ken (JP)**

(74) Representative: **Rees, David Christopher, Kilburn & Strode 30 John Street, London WC1N 2DD (GB)**

(54) **Die-bonding electroconductive paste.**

(57) A die-bonding electroconductive paste for bonding a semiconductor material containing at least one element having the same valency as the valency of the semiconductor element to be die-bonded, or a compound of that element and a reducing substance, permitting ohmic contact to be effected at a temperature of not less than 100°C.

EP 0 205 686 A1

## DIE-BONDING ELECTROCONDUCTIVE PASTE.

The present invention relates to a die-bonding electroconductive paste, for example a die-bonding electroconductive paste which permits ohmic contact with a semiconductor material.

Known die-bonding electroconductive pastes include those produced by blending fine electroconductive powders of such metals as gold, silver, copper, nickel, rhodium, palladium and silver-palladium with such heat-resistant binders as epopy resin, polyimide, glass glaze, and cement, with or without a solvent. These die-bonding electroconductive pastes are used for die-bonding semiconductor materials on to substrates. When die-bonding with such an electroconductive paste is effected in the case of a semi conductor material intended to allow the flow of a weak current, the die-bonded part becomes non-ohmic and can only function satisfactorily with difficulty. For the die-bonded semiconductor material to produce ohmic contact, therefore, the semiconductor material is reqired to have its rear surface subjected in advance to an undercoat electrode treatment by the vacuum deposition of gold, for example. Furthermore, this contact which is formed elaborately is unstable compared with the contact obtainable by the Au-Si eutectic method, for example.

It is an object of the present invention to provide a die-bonding electroconductive paste capable of permitting ohmic contact with a semiconductor material without requiring any under coat electrode treatment.

According to the invention there is provided a die-bonding electroconductive paste for bonding a semiconductor material, characterised in that the paste contains a first component comprising at least one element having the same valency as the valency of the semiconductor material to be die-bonded or a compound of that element, and a second component comprising a reducing substance, thereby permitting ohmic contact to be effected at a temperature of not less than 100°C.

Thus a electroconductive paste in accordance with the present invention may be produced by blending a conventional electroconductive paste with a reducing substance, and at least one element, or compound of an element, having the same valency as the valency of the semiconductor material to be die-bonded and therefore having also the ability to match its chemical affinity with the semiconductor.

Examples of the material to be added for matching the chemical affinity are as follows: such tetravalent elements as silicon, germanium, carbon, titanium, zirconium, tin, hafnium and lead, preferably silicon, germanium, carbon, titanium and zirconium, when the semiconductor incorporates elements of Group IV such as silicon and germanium; such trivalent elements as boron, aluminium, scandium, gallium, yttrium, indium, lanthanoids and actinoids, preferably gallium, aluminium, indium and yttrium, and such pentavalent elements as nitrogen, phosphorus, vanadium, arsenic, niobium, antimony, tantalum and bismuth, preferably arsenic, phosphorus, vanadium, tantalum and niobium when the semiconductor incorporates elements of Group III-V such as potassium-phosphorus, gallium-arsenic, gallium-arsenic-phosphorus, gallium-aluminium-arsenic and gallium-aluminiumarsenic-phosphorus; and such divalent elements as beryllium, magnesium, calcium, strontium, barium, zinc, cadmium and mercury, preferably zinc and cadmium, and such hexavalent elements as chromium, molybdenum, tungsten, oxygen, sulphur, selenium and tellurium, preferably selenium and tellurium, when the semiconductor incorporates elements of Groups II-VI such as sinc-sulphur, zinc-selenium, sinc-tellurium, mercury-cadmium-tellurium and cadmium-tellurium.

One member or mixture of two or more members selected from the elements enumerated above can be used in the form of a simple element or compound. When the element to be die bonded is a simple element such as silicon or germanium, at least one element is preferably used for matching the chemical affinity of that simple element. When the element is a composite system such as a combination of elements of Groups III-V or Groups II-VI, for example, at least one each of the chemical affinity matching elements corresponding to the valencies of the component elements in the combination is preferably used. The amount of the affinity-matching component to be used may be 5 to 90% by weight, preferably 20 to 60% by weight, in terms of the simple element or elements, based on the total amount of the electroconductive paste. The component is preferably used in a finely divided simple elemental form, 0.5 to 50μm, preferably 1 to 10 μm, in average particle diameter. When the simple element is gaseous or unstable, it may be used in the form of a stable compound of that element. Examples of this compound are inorganic compounds such as sulphides, nitrides, oxides, carbides and hydrides, and organic compounds.

The reducing substance to be used in the electroconductive paste of this invention can be selected from a wide variety of substances. Specific examples include metal hydrides such as $CuH_2$, $HiH_2$, $CoH_2$, $FeH_2$, $FeH_6$,

CrH, $WH_3$, $TiH_4$, $SiH_4$, $GeH_4$, $ZrH_4$, $HfH_4$, $Na[BH_4]$ and $Li[BH_4]$, carbides such as $Al_2C_6$, $LaC_2$, $CeC_2$, $NdC_2$, $SmC_2$, $YC_2$, $ThC_2$, $VC_2$, SiC, TiC, HfC, ZrC, $Cr_3C_2$, VC NbC, TaC, $Mo_2C$, MoC, $W_2C$, WC, $Cr_4C$, $Fe_3C$ and $B_4C$, higher fatty acids such as lauric acid, myristic acid, palmitic acid, stearic acid, oleic acid and behenic acid, organic metal compounds such as dimethyl zinc, diethyl zinc, triethyl alumimium, isopropyl aluminium, Grignard reagent, metal salts of naphthenic acid, metal salts of acetic acid, and metal salts of propionic acid, organic silicon compounds, and hydrazine. One member or mixture of two or more members selected from these reducing substances can be used. The amount of the reducing substance to be used may be 0.5 to 50% by weight, preferably 1 to 10% by weight, based on the total amount of the electroconductive paste.

The chemical affinity matching material and the reducing substance described above are preferably blended with any of the conventional die-bonding electroconductive pastes. These conventional pastes are generally produced by blending finely divided powders of such metals as gold, silver, copper, nickel, rhodium, palladium and silver-palladium and heat-resistant binders such as epoxy resin, polyimide, polyamideimide, glass glaze, and cement with or without a solvent. The aforementioned finely divided powder is, for example, finely powdered gold or silver having an average particle diameter of 1 to 20 μm, preferably 1 to 5μm. The amount of the electroconductive powder to be used is generally 0 to 80% by weight, preferably 25 to 60% by weight, based on the total amount of the electroconductive paste of this invention.

Typical examples of the epoxy resin are epichlorohydrin-bisphenol A type, novolak type, $\beta$ - methylepichlo-hydrin type, alicyclic types (cyclic oxylan type, glycidyl ether type and glycidyl ester type), heteroalicyclic types (polyglycol ether type, glycol ether type and epoxidized aliphatic unsaturated compound type), epoxidized animal and vegetable oils, polycarboxylic ester type, aminoglycidyl type, chlorinated type, and resorcin type. Of these examples, preferable are epichloro-hydrinbispenol A type and novolak type. The epoxy resin is used in combination with a curing agent. Examples of the curing agent are amines such as diethylene triamine, benzyl dimethylamine, diaminodiphenylamine, diaminodiphenyl sulphon and polyamides, acid anhydrides such as phthalic anhydride, maleic anhydride, hexahydrophthalic anhydride, methyl nadic anhydride, pyrromellitic anhydride and benzophenone tetracarboxylic anhydride, and phenol novolak. The aforementioned binder may be used in an amount of 3 to 50% by weight, preferably 10 to 30% by weight, based on the total amount of the electroconductive paste.

For the component described above to be blended in the form of paste, a solvent is preferably used. This solvent is only required to be capable of dissolving the binder. Glycol ethers such as ethylene glycol monomethyl ether, ethylene glycol monoethyl ether, ethylene glycol monobutyl ether are available for epoxy resins and methyl pyrrolidone is available for polyimide, for example. This solvent is generally used in an amount of 0 to 30% by weight, preferably 3 to 20% by weight, based on the total amount of the electroconductive paste.

The electroconductive paste may be obtained by putting the components together and thoroughly kneading them. The ohmic contact of the electroconductive paste with a semiconductor material to be die-bonded can be obtained by applying the paste onto the semiconductor material without first subjecting the semiconductor material to any undercoat electrode treatment, and then effecting die-bonding of the resultant superposed elements at a temperature of not less than 100°C, preferably in the range of 150°C to 250°C. Examples of semiconductor elements on which ohmic contact can be obtained include VLSI, LSI, IC transistor, diode, LED, phototransistor, photo cell, and semiconductor laser.

The invention will now be described in more detail with reference to following examples.

Example 1.

Finely powdered silver (average particle diameter not exceeding 10 μm)      50% by weight

Finely powdered silicon (average particle diameter not exceeding 10μm)      20% by weight.

Epoxy resin (a mixture of 10 parts by weight of phenol novolak epoxy with 8 parts by weight of hexahydrophthalic anhydride)      20% by weight.

Ethylene glycol monobutyl ether      5% by weight.

Cobalt naphthenate      5% by weight.

In a mortar, the components described above were throughly kneaded to produce a paste-like mixture.

Through the medium of the electroconductive paste so produced, a silicon diode having no gold treatment given in advance to its rear surface was die-bonded to a substrate and then wire bonded. The diode produced was tested for its diode property. The die-bonding and post cure was carried out at 150°C for one hour. The diode property was determined by fixing the value of electric current at 10μA and measuring, at the resultant voltage, the voltage and resistance of the die-bonded part. The results are shown in Table 1.

Controls 1-2

For comparison, a silicon diode having a gold treatment given in advance to its rear surface was die-bonded with a conventional silver paste to a substrate (Control 1) and a silicon diode having no treatment given to its rear surface was die-bonded with a conventional silver paste to a substrate (Control 2). The resultant products were tested for their diode property by following the same procedure as for Example 1. The results are shown in Table 1.

TABLE 1.

| Sample | Voltage (mV). | Resistance (Ω) |
|--------|---------------|----------------|
| Example 1 | 2.5 | 250 |
| Control 1 | 5 | 500 |
| Control 2 | 200 | 20,000 |

It can be seen from Table 1 that by the use of the electroconductive paste of this invention, a silicon diode having more desirable contact resistance than a conventional silicon diode which has undergone an expensive gold treatment can be mass-produced at a very low cost.

Example 2.

Finely powdered silver (average particle
diameter not exceeding 10μm)        30% by weight.

Finely powdered germanium (average particle
diameter not exceeding 10μm)        40% by weight.

Epoxy resin (a mixture of 10 parts by weight
of phenol novolak epoxy with 8 parts by
weight of hexahydrophthalic
anhydride)                          20% by weight.

Ethylene glycol monbutyl ether      8% by weight.

$NiH_2$                             2% by weight.

In a mortar, the components shown above were kneaded thoroughly to produce a paste-like mixture. Using the electroconductive paste so produced, a silicon phototransistor having no gold treatment given in advance was assembled by following the procedure of Example 1. The product was tested for its transistor property by following the procedure of Example 1. The results are shown in Table 2.
In the test, V cc was fixed at 1.2V.
Controls 3-4
For comparision, a silicon phototransistor having gold treatment given in advance to its rear surface was die-bonded with an Au-Si eutectic paste to a substrate (Control 3) and a silicon phototransistor having no gold treatment given in advance was die-bonded with a conventional silver paste to a substrate (Control 4).

The products were tested by following the procedure of Example 2. The results are shown in Table 2.

TABLE 2.

| Sample | Amperage (mA) |
| --- | --- |
| Example 2 | 480 |
| Control 3 | 470 |
| Control 4 | 0 |

It can be seen from Table 2 that even in the production of silicon phototransistor, the use of the electroconductive paste of this invention results in an advantageous effect and brings into question the necessity for the conventional expensive gold treatment. The experiment has demonstrated that the electroconductive paste of this invention should be effective in the die-bonding of all silicon elements such as in IC, LSI or super LSI which have previously required a rear surface treatment.

Example 3.

| | |
| --- | --- |
| Finely powdered silver (average particle diameter not exceeding 10μm) | 30% by weight. |
| Finely powdered vanadium (average particle diameter not exceeding 10μm) | 20% by weight. |
| Finely powdered potassium (average particle diameter not exceeding 10μm) | 20% by weight. |
| Epoxy resin of Example 1 | 20% by weight. |
| Ethylene glycol monobutyl ether | 8% by weight. |
| $CoH_2$ | 2% by weight. |

In a mortar, the components shown above were thoroughly blended to produce a paste-like mixture. Using the electroconductive paste so produced, a Ga-Al-As diode having no gold treatment given advance was assembled by following the procedure of Example 1. The product thus obtained was tested for its diode property by following the procedure of Example 1. The results are shown in Table 3.

Controls 5-6.

For comparision, a Ga-Al-As diode having a gold treatment given in advance to its rear surface was die bonded with a conventional silver paste (Control 5) and a Ga-Al-As diode having no gold treatment given in advance was die bonded with a conventional silver paste (Control 6). The products were tested by following the procedure of Example 1. The results are shown in Table 3.

TABLE 3.

| Sample | Voltage (mV) | Resistance ($\Omega$) |
|---|---|---|
| Example 3 | 1.8 | 180 |
| Control 5 | 3 | 300 |
| Control 6 | 1500 | 150,000 |

It can be seen from Table 3 that by the use of the electroconductive paste of the present invention, a diode having a more desirable contact resistance than a conventional counter-type diode which has undergone an expensive gold treatment can be mass-produced at a very low cost.

Example 4.

Finely powdered silver (average particle diameter not exceeding 10μm)                50% by weight.

Finely powdered germanium (average particle
diameter not exceeding 10µm)          20% by weight.

Epoxy resin of Example 1              20% by weight.

Ethylene glycol monobutyl ether        5% by weight.

$ZrH_4$                                5% by weight.

In a mortar, the components shown above were thoroughly blended to produce a paste like mixture. Using the electroconductive paste so produced, a germanium diode having no gold treatment given in advance was assembled by following the procedure of Example 1. The product was tested for its diode property following the procedure of Example 1. The results are shown in Table 4. In the text, V cc was fixed at 0.2 V.

Controls 7-8

For comparison, a germanium diode having a gold treatment given to its rear surface was die bonded with an Au-Si eutectic type paste (Control 7) and a germanium diode having no gold treatment given in advance was die bonded with a conventional silver paste (Control 8). The products were tested by following the procedure of Example 2. The results are shown in Table 4.

TABLE 4.

| Sample | Amperage (mA) |
| --- | --- |
| Example 4 | 1,500 |
| Control 7 | 1,450 |
| Control 8 | 0 |

-12-

Example 5.

Finely powdered silver (average particle
diameter not exceeding 10μm)           50% by weight.

Finely powdered CdTe (average particle
diameter not exceeding 10μm)           20% by weight.

Epoxy resin of Example 1               20% by weight.

Ethylene glycol monobutyl ether        5% by weight.

CrH                                    5% by weight.

In a mortar, the components shown above were throughly
blended to produce a paste-like mixture.  Using the electroconductive paste so produced, a Cd-Te diode (N or P)
having no gold treatment given in advance was assembled
by following the procedure of Example 1.  The product
was tested by following the procedure of Example 1.
The results are shown in Table 5.
In this test, V cc was fixed at 0.2
Controls 9-10

For comparison, a Cd-Te diode having a gold treatment
given to is rear surface was die bonded with an Au-Si
eutectic paste (Control 9) and a Cd-Te diode having no
treatment given in advance was die bonded with a conventional
silver paste (Control 10).  The products thus obtained
were tested by following the procedure of Example 2.
The results are shown in Table 5.

TABLE 5.

| Sample | Amperage (mA) |
| --- | --- |
| Example 5 | 1,200 |
| Control 9 | 1,180 |
| Control 10 | 0 |

It can be seen from the results given above that in all the elements involved, the electroconductive pastes according to the present invention manifest advantageous effects. They are expected to bring about the same effects in integrated circuits.

CLAIMS.

1. A die-bonding electroconductive paste for bonding a semi-conductor material, characterised in that the paste contains a first component comprising at least one element having the same valency as the valency of the semiconductor material to be die-bonded or a compound of that element, and a second component comprising a reducing substance, thereby permitting ohmic contact to be effected at a temperature of not less than 100°C.

2. An electroconductive paste as claimed in Claim 1 characterised in that it comprises 5 to 90% by weight of the first component expressed in terms of the element, 0.5 to 50% by weight of the reducing substance, 0 to 80% by weight of finely powdered electroconductive substance, 3 to 45% by weight of a binder, and 0 to 30% by weight of a solvent.

3. An electroconductive paste as claimed in Claim 1 or Claim 2, characterised in that the semiconductor material consists of an element from Group IV, elements of Groups III-V, or elements of Groups II-VI, in dependence upon the desired valency.

4. An electroconductive paste as claimed in Claim 2 or Claim 3 characterised in that the fine electroconductive powder is gold, silver, copper, nickel, rhodium, palladium, silver-palladium or a mixture of any of these metals.

5. An electroconductive paste as claimed in any of Claims 2 to 4 characterised in that the fine electroconductive powder has an average particle diameter of 1 to 20μm.

6. An electroconductive paste as claimed in any preceding claim characterised in that the reducing substance is a metal hydride, a metal carbide, a higher fatty acid, an organic metal compound, an organic silicon compound or hydrazine.

7. An electroconductive paste as claimed in any of Claims 2 to 6 characterised in that the binder is an epoxy resin or a glycol ether.

8. An electroconductive paste as claimed in any preceding claim characterised in that the first component has an average particle diameter of 0.5 to 50μm.

9. An electroconductive paste as claimed in any preceding claim characterised in that the semiconductor material is an element from Group IV and the first component is a tetravalent element comprising one or more of silicon, germanium, carbon, titanium, zirconium, tin, hafnium and lead.

10. An electroconductive paste as claimed in any of Claims 1 to 8 characterised in that the semiconductor material is an element of Groups III-V and the first component is a trivalent element comprising one or more or boron, aluminium, scandium, gallium, yttrium, indium, lanthanoids and actinoids with a pentavalent element comprising one or more of nitrogen, phosphorous, vanadium, arsenic, niobium, antimony, tantalum and bismuth.

11.    An electroconductive paste as claimed in any of Claims 1 to 8 characterised in that the semiconductor material is an element of Groups II-VI and the first component is a divalent element comprising one or more of beryllium, magnesium, zinc, cadmium and mercury with a hexavalent element comprising one or more of chromium, molybdenum, tungsten, oxygen, sulphur, selenium and tellurium.

12.    An electroconductive paste as claimed in any preceding claim characterised in that it comprises 20 to 60% by weight of the first component, 1 to 10% by weight of the reducing substance, 25 to 60% by weight of fine semiconductor powder, 10 to 30% by weight of binder and 3 to 20% by weight of solvent.

European Patent Office

**EUROPEAN SEARCH REPORT**

Application number

EP 85 30 4206

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | FR-A-2 505 543 (SUMITOMO) * Claims 1,2,5; page 3, lines 18-26; page 10, lines 8-12 * | 1 | H 01 L 23/48 |
| A | | 2-9,12 | |
| | --- | | |
| Y | FR-A-2 515 675 (C.G.E.) * Claim 1 * | 1 | |
| A | | 2-4,9, 12 | |
| | --- | | |
| Y | GB-A-1 558 764 (FERRANTI) * Claims 1,4,10,14; page 3, lines 56-63 * | 1 | |
| A | | 2-4,6, 12 | TECHNICAL FIELDS SEARCHED (Int. Cl.4)  H 01 L |
| | --- | | |
| A | US-A-4 356 505 (BELL) * Claim 1 * | 4,7,8 | |
| | --- | | |
| A | EP-A-0 110 307 (BURROUGHS) * Claims 1,2,9; page 6, lines 12-15 * | 4,8-10 | |
| | --- | | |
| A | US-A-4 293 451 (ROSS)  * Claims 14,15,19,20 * | 2,3,9- 11 | |
| | ---     -/- | | |

The present search report has been drawn up for all claims

| Place of search | Date of completion of the search | Examiner |
|---|---|---|
| THE HAGUE | 04-02-1986 | DE RAEVE R.A.L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82

European Patent Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | DE-A-2 829 917 (SEMIKRON)<br>* Claims 1-3 * | 4,9,11 | |
| | ----- | | |

TECHNICAL FIELDS SEARCHED (Int. Cl.4)

The present search report has been drawn up for all claims

| Place of search | Date of completion of the search | Examiner |
|---|---|---|
| THE HAGUE | 04-02-1986 | DE RAEVE R.A.L. |